# EUROPÄISCHE PATENTSCHRIFT

(11) **EP 2 698 048 B1**
(45) Veröffentlichungstag und Bekanntmachung des Hinweises auf die Patenterteilung: **14.06.2017**
(21) Anmeldenummer: 12714249.5
(22) Anmeldetag: 20.03.2012
(51) Int. Cl.: H05K 7/14

(54) **LEISTUNGSELEKTRONISCHES SCHALTSYSTEM**
POWER ELECTRONIC SWITCHING SYSTEM
SYSTÈME DE COMMUTATION ÉLECTRONIQUE DE PUISSANCE

(30) Priorität: 14.04.2011 DE 202011005290 U; 03.05.2011 DE 202011100208 U
(43) Veröffentlichungstag der Anmeldung: 19.02.2014
(73) Patentinhaber: ABB Schweiz AG, 5400 Baden (CH)
(72) Erfinder: WEISS, Michael, CH-5405 Winterthur (CH); LÜSCHER, Roger, CH-4500 Solothurn (CH); IORDANIDIS, Arthouros, CH-5400 Baden (CH); CRANGANU-CRETU, Bogdan, CH-5442 Fislisbach (CH); STEINKE, Jürgen, 79774 Albbruck (DE)
(74) Vertreter: ABB Patent Attorneys
(86) Internationale Anmeldenummer: PCT/EP2012/054899
(87) Internationale Veröffentlichungsnummer: WO 2012/139862

(56) Entgegenhaltungen:
- EP-A2- 1 953 908
- WO-A2-2008/005485
- DE-A1- 10 054 962
- US-A1- 2004 201 972

## Beschreibung

### Technisches Gebiet

Die vorliegende Erfindung bezieht sich auf das Gebiet der Leistungselektronik. Sie betrifft ein leistungselektronisches Schaltsystem gemäss dem Oberbegriff des unabhängigen Anspruchs.

### Stand der Technik

Leistungselektronische Schaltsysteme sind heute hauptsächlich in Umrichterschaltungen für verschiedensten Anwendungen zu finden. Typischerweise umfasst ein solches leistungselektronisches Schaltsystem eine Vielzahl an Schalteinheiten und eine Montageeinheit, wobei die Montageeinheit eine Haltevorrichtung aufweist, an der die Gehäuse der Schalteinheiten angeordnet sind. Ein gattungsgemässes leistungselektronisches Schaltsystem ist in der WO 2008/005485 A2 angegeben. Beispielsweise in Fig. 5A und Fig. 5B der WO 2008/005485 A2 weist die Haltevorrichtung mehrere Schienen auf, wobei immer zwei solcher Schienen ein Gehäuse tragen und die Gehäuse daran fixiert ist. Die Montageeinheit, die Haltevorrichtung und die Schienen sind typischerweise aus Metall und damit aus einem elektrisch leitenden Material. Typischerweise umfasst eine solche Schalteinheit das bereits erwähnte Gehäuse, in welchem mindestens ein Schaltmodul angeordnet ist, welches Schaltmodul wiederum einen oder mehrere ansteuerbare Leistungshalbleiterschalter umfasst. Im Falle mehrerer ansteuerbarer Leistungshalbleiterschalter sind diese beispielsweise zu einer Halbbrückenschaltung oder einer Vollbrückenschaltung verschaltet. Jedes Schaltmodul ist mit dem zugehörigen Gehäuse verbunden, wobei dann die Schaltmodule und die Gehäuse üblicherweise auf einem einheitlichen Spannungspotential, insbesondere Erdpotential liegen.

Die US 2004/0201972 A1 betrifft ein gattungsgemässes leistungselektranisches Schaltsystem mit einer Vielzahl an Schalteinheiten. Ferner ist in der EP 1 953 908 A2 ein Trägermodul für einen Wechselrichter angegeben, bei welchem Trägermodul aber das Gehäuse einer jeden Schalteinheit kein Material aufweist, welches zur zumindest teilweisen Abschirmung gegen ein elektrisches und magnetisches Feld dient. Darüber hinaus ist in der DE 100 54 962 A1 ein Leistungsmodul angegeben, welches ein Material aufweist, welches zur zumindest teilweisen Abschirmung gegen ein elektrisches und magnetisches Feld dient.

Problematisch bei einem leistungselektronischen Schaltsystem nach der WO 2008/005485 A2 ist, dass die Gehäuse der Schalteinheiten auf einem einheitlichen Spannungspotential liegen müssen, da es sonst zu unerwünschten Ausgleichströmen kommen würde. Ist es aber beispielsweise durch eine vorgegebene Anwendung notwendig, dass die Gehäuse der Schalteinheiten auf unterschiedlichen Spannungspotentialen liegen, so ist dies mit einem leistungselektronischen Schaltsystem nach der WO 2008/005485 A2 nicht möglich. Desweiteren ist der Aufbau des leistungselektronischen Schaltsystems der WO 2008/005485 A2 kompliziert und benötigt viel Platz, da für jede Schalteinheit zwei Schienen notwendig sind, die zusätzlich an einer Rahmenstruktur befestigt werden müssen. Die Herstellung eines solchen leistungselektronischen Schaltsystems ist damit aufwendig, benötigt viel Zeit und Erfahrung bei der Montage und ist somit dementsprechend teuer.

### Darstellung der Erfindung

Aufgabe der Erfindung ist es deshalb, ein leistungselektronisches Schaltsystem anzugeben, welches es den Gehäusen der Schalteinheiten des Schaltsystems ermöglicht, untereinander unterschiedliche Spannungspotentiale aufzuweisen und welches zudem einfach und platzsparend zu realisieren und problemlos zu montieren ist. Diese Aufgabe wird durch die Merkmale des Anspruchs 1 gelöst. In den abhängigen Ansprüchen sind vorteilhafte Weiterbildungen der Erfindung angegeben.

Das erfindungsgemässe leistungselektronische Schaltsystem umfasst eine Vielzahl an Schalteinheiten, wobei jede Schalteinheit ein Gehäuse und mindestens ein innerhalb des Gehäuses angeordnetes Schaltmodul aufweist. Darüber hinaus umfasst das leistungselektronische Schaltsystem eine Montageeinheit, wobei die Montageeinheit eine Haltevorrichtung aufweist, an welcher Haltevorrichtung die Gehäuse der Schalteinheiten angeordnet sind.

Nach der Erfindung weist die Haltevorrichtung nun ein Isolationsmaterial zur elektrischen Isolation der Haltevorrichtung gegenüber den Gehäusen der Schalteinheiten und gegenüber den Gehäusen der Schalteinheiten untereinander auf. Zudem weist das Gehäuse einer jeden Schalteinheit ein Material zur zumindest teilweisen Abschirmung eines elektrischen und magnetischen Feldes auf.

Durch diese Haltevorrichtung kann vorteilhaft erreicht werden, dass die Gehäuse der Schalteinheiten untereinander auf unterschiedlichen Spannungspotentialen liegen können, ohne dass unerwünschte Ausgleichströme fliessen. Mit Vorteil vermeidet die Haltevorrichtung auch mögliche Teilentladungen, welche aufgrund der vorstehend genannten unterschiedlichen Spannungspotentiale auftreten können. Desweiteren ist der Aufbau des erfindungsgemässen leistungselektronischen Schaltsystems durch die Montageinheit und deren Haltevorrichtung sehr einfach und platzsparend aufgebaut, da die Haltevorrichtung mehrere Schalteinheiten aufnehmen kann. Zudem ist das leistungselektronische Schaltsystem durch die Montageinheit und deren Haltevorrichtung entsprechend robust. Ferner ist die Realisierung und Herstellung des leistungselektronischen Schaltsystems schnell und problemlos möglich, da der Montageaufwand gering ist und die Montage ohne grössere Erfahrung erfolgen kann. Das erfindungsgemässe leistungselektronische Schaltsystem ist demzufolge sehr kostengünstig herzustellen. Desweiteren dient das Gehäuse einer jeden Schalteinheit mit Vorteil der zumindest teilweisen Abschirmung bzw. Schwächung elektrischer und magnetischer Felder, welche von dem mindestens einen Schaltmodul innerhalb des Gehäuses ausgehen können, sowie der zumindest teilweisen Abschirmung bzw. Schwächung elektrischer und magnetischer Felder, welche ausserhalb des Gehäuses, beispielsweise hervorgerufen durch benachbarten Schalteinheiten und/oder elektrische Peripheriekomponenten, vorliegen können.

Diese und weitere Aufgaben, Vorteile und Merkmale der vorliegenden Erfindung werden aus der nachfolgenden detaillierten Beschreibung bevorzugter Ausführungsbeispiele der Erfindung in Verbindung mit der Zeichnung offensichtlich.

### Kurze Beschreibung der Zeichnungen

Es zeigen:
- Fig. 1: eine schematische dreidimensionale Darstellung einer Ausführungsform eines erfindungsgemässen leistungselektronischen Schaltsystems,
- Fig. 2: eine Vorderansicht eines Ausschnitts der Ausführungsform des erfindungsgemässen leistungselektronischen Schaltsystems nach Fig. 1,
- Fig. 3: ein Ausschnitt der schematische dreidimensionale Darstellung der Ausführungsform des erfindungsgemässen leistungselektronischen Schaltsystems nach Fig. 1,
- Fig. 4: eine schematische dreidimensionale Darstellung einer weiteren Ausführungsform des erfindungsgemässen leistungselektronischen Schaltsystems,
- Fig. 5: eine Explosionsdarstellung eines Ausschnitts der schematische dreidimensionale Darstellung der Ausführungsform des erfindungsgemässen leistungselektronischen Schaltsystems nach Fig. 4,
- Fig. 6: ein Ausschnitt der schematische dreidimensionale Darstellung der Ausführungsform des erfindungsgemässen leistungselektronischen Schaltsystems nach Fig. 4 und
- Fig. 7: eine Schnittdarstellung der Ausführungsform des erfindungsgemässen leistungselektronischen Schaltsystems nach Fig. 4.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

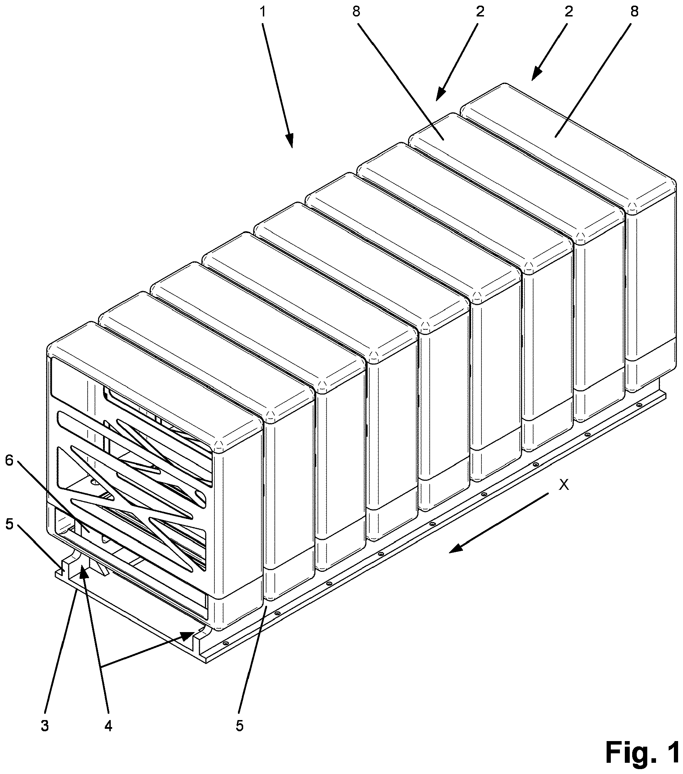

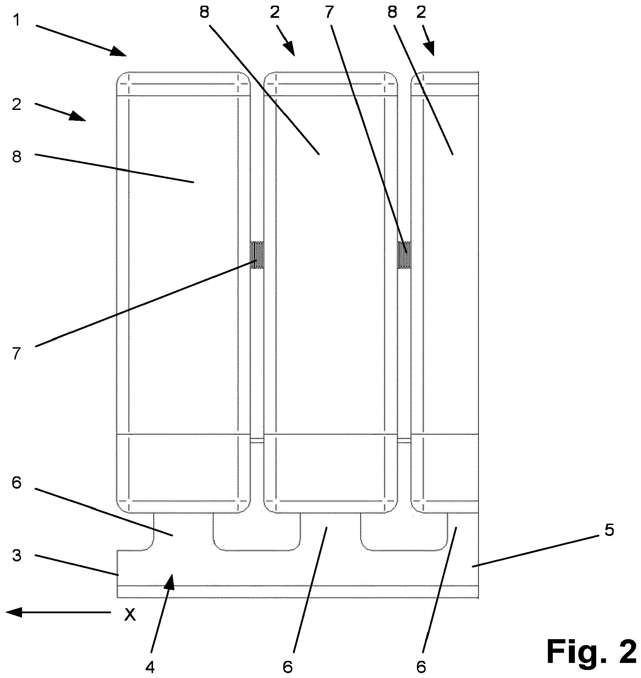

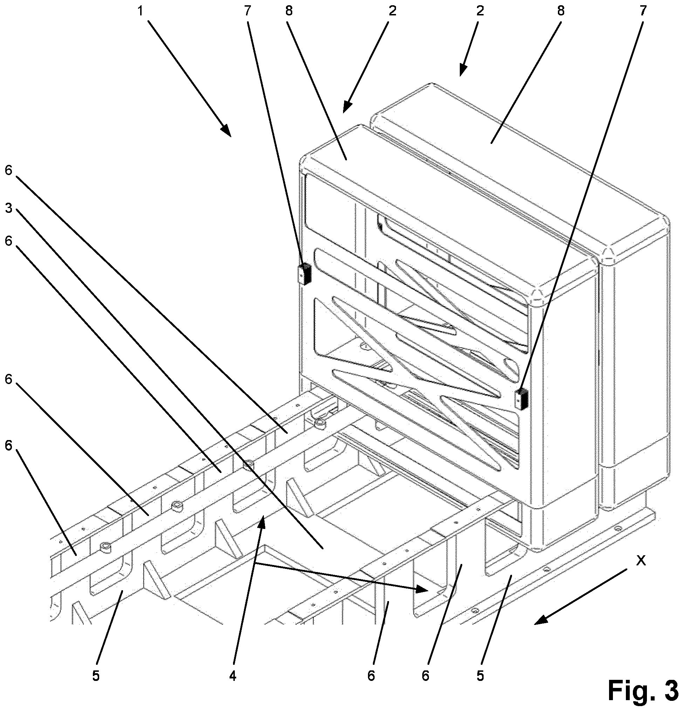

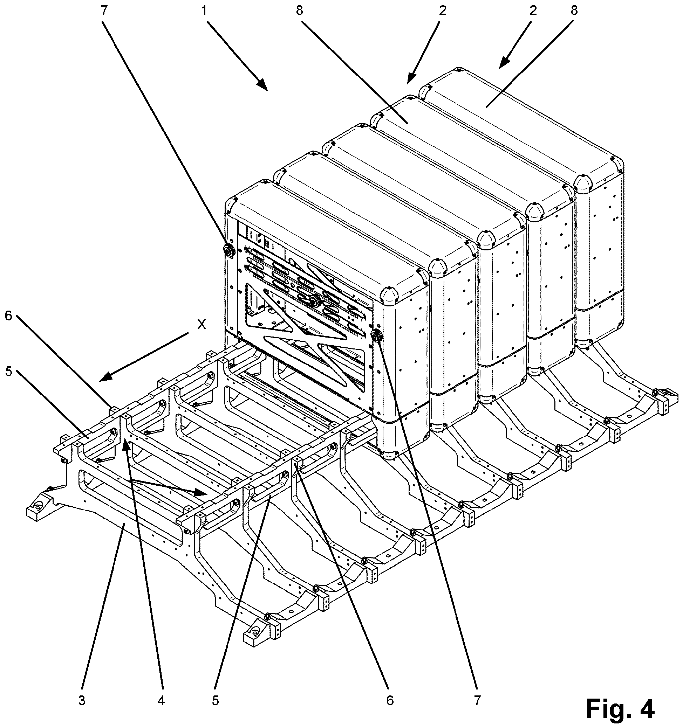

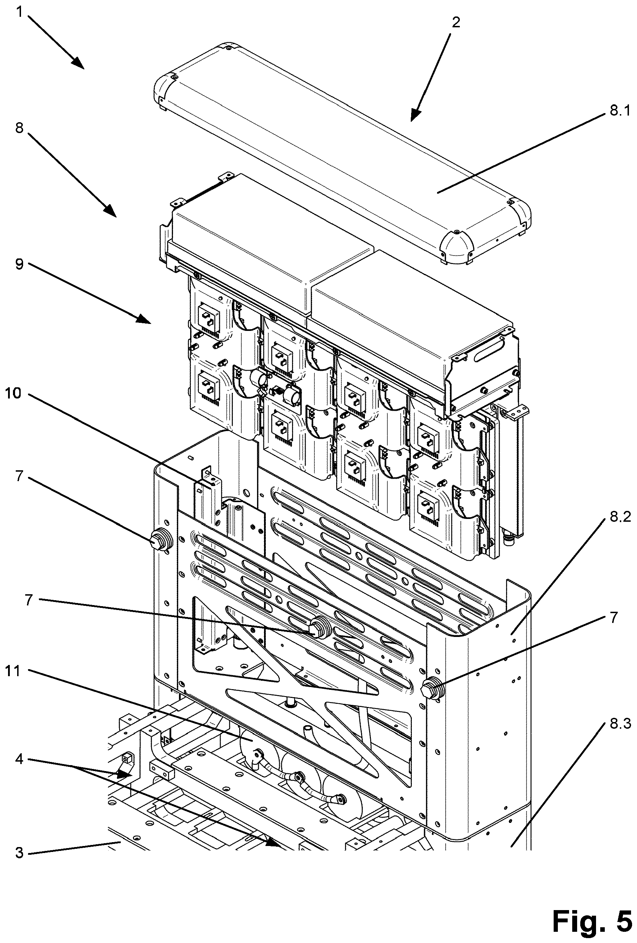

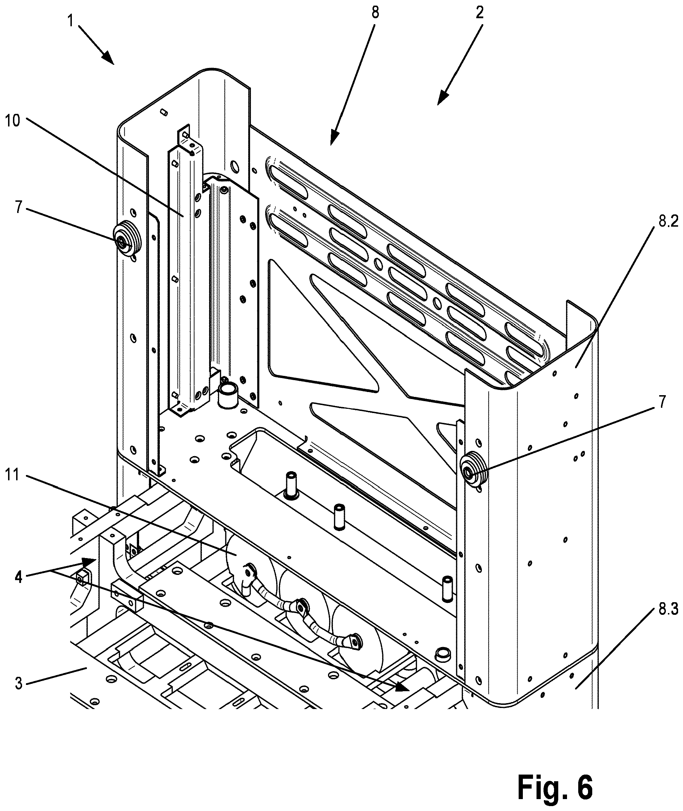

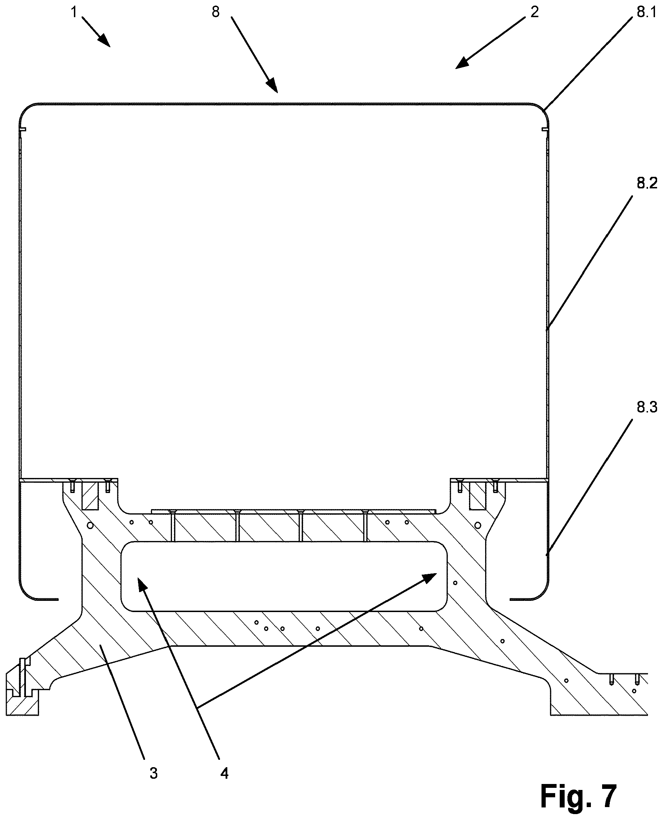

Fig. 1 zeigt eine schematische dreidimensionale Darstellung einer Ausführungsform eines erfindungsgemässen leistungselektronischen Schaltsystems 1. Ferner zeigt Fig. 2 eine Vorderansicht eines Ausschnitts der Ausführungsform des erfindungsgemässen leistungselektronischen Schaltsystems 1 nach Fig. 1. Darüber hinaus ist in Fig. 3 ein Ausschnitt der schematische dreidimensionale Darstellung der Ausführungsform des erfindungsgemässen leistungselektronischen Schaltsystems 1 nach Fig. 1 dargestellt. Fig. 4 zeigt ferner eine schematische dreidimensionale Darstellung einer weiteren Ausführungsform des erfindungsgemässen leistungselektronischen Schaltsystems 1. Weiterhin ist in Fig. 5 eine Explosionsdarstellung eines Ausschnitts der schematische dreidimensionale Darstellung der Ausführungsform des Schaltsystems nach Fig. 4 dargestellt. Fig. 6 zeigt einen Ausschnitt der schematischen dreidimensionalen Darstellung der Ausführungsform des Schaltsystems nach Fig. 4 und in Fig. 7 ist schliesslich eine Schnittdarstellung der Ausführungsform des Schaltsystems nach Fig. 4 gezeigt.

Das erfindungsgemässe leistungselektronische Schaltsystem 1 umfasst eine Vielzahl an Schalteinheiten 2, wobei jede Schalteinheit 2 ein Gehäuse 8 und mindestens ein innerhalb des Gehäuses 8 angeordnetes Schaltmodul 9 aufweist. Das mindestens eine Schaltmodul 9 ist in Fig. 1, Fig. 2, Fig. 3, Fig. 4, Fig. 6 und Fig. 7 der Übersichtlichkeit halber nicht dargestellt. Das vorstehend genannte Schaltmodul 9 umfasst vorzugsweise einen oder mehrere ansteuerbare Leistungshalbleiterschalter. Im Falle mehrerer ansteuerbarer Leistungshalbleiterschalter sind diese beispielsweise zu einer Halbbrückenschaltung oder einer Vollbrückenschaltung verschaltet. Es sei darauf hingewiesen, dass jegliche, dem Fachmann bekannte Verschaltungen der ansteuerbaren Leistungshalbleiterschalter denkbar sind. Der jeweilige ansteuerbare Leistungshalbleiterschalter ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar, einen ansteuerbaren Leistungshalbleiterschalter beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden.

Gemäss Fig. 1 umfasst das leistungselektronische Schaltsystem 1 zudem eine Montageeinheit 3, wobei die Montageeinheit 3 eine Haltevorrichtung 4 aufweist, an welcher Haltevorrichtung 4 die Gehäuse 8 der Schalteinheiten 2 angeordnet sind. Erfindungsgemäss weist die Haltevorrichtung 4 nun ein Isolationsmaterial zur elektrischen Isolation der Haltevorrichtung 4 gegenüber den Gehäusen 8 der Schalteinheiten 2 und gegenüber den Gehäusen 8 der Schalteinheiten 2 untereinander auf. Zudem weist das Gehäuse 8 einer jeden Schalteinheit 2 ein Material zur zumindest teilweisen Abschirmung eines elektrischen und magnetischen Feldes auf.

Durch diese Haltevorrichtung 4 wird mit Vorteil erreicht, dass die Gehäuse 8 der Schalteinheiten 2 untereinander auf unterschiedlichen Spannungspotentialen liegen können, ohne dass unerwünschte Ausgleichströme fliessen. Die Haltevorrichtung 4 dient zudem der Vermeidung möglicher Teilentladungen, welche aufgrund der vorstehend genannten unterschiedlichen Spannungspotentiale auftreten können. Desweiteren ist der Aufbau des erfindungsgemässen leistungselektronischen Schaltsystems 1 durch die Montageinheit 3 und deren Haltevorrichtung 4 sehr einfach und platzsparend aufgebaut, da die Haltevorrichtung 4 mehrere Schalteinheiten 2 aufnehmen kann. Zudem ist das leistungselektronische Schaltsystem 1 durch die Montageinheit 3 und deren Haltevorrichtung 4 entsprechend robust. Die Realisierung und Herstellung des leistungselektronischen Schaltsystems 1 ist ferner schnell und problemlos möglich, da der Montageaufwand gering ist und die Montage ohne grössere Erfahrung erfolgen kann. Das erfindungsgemässe leistungselektronische Schaltsystem 1 ist demnach äusserst kostengünstig herzustellen. Darüber hinaus dient das Gehäuse 8 einer jeden Schalteinheit 2 mit Vorteil der zumindest teilweisen Abschirmung bzw. Schwächung elektrischer und magnetischer Felder, welche von dem mindestens einen Schaltmodul 9 innerhalb des Gehäuses 8 ausgehen können, sowie der zumindest teilweisen Abschirmung bzw. Schwächung elektrischer und magnetischer Felder, welche ausserhalb des Gehäuses 8, beispielsweise hervorgerufen durch benachbarten Schalteinheiten 2 und/oder elektrische Peripheriekomponenten, vorliegen können. Vorzugsweise wird als Material des Gehäuses 8 ein Metall oder eine Metalllegierung eingesetzt. Das Gehäuse 8 selbst kann dann aus einem Metall oder eine Metalllegierung oder beidem sein. Denkbar ist es auch, dass eine Gehäusestruktur mit einem Metall, einer Metalllegierung oder mit beidem beschichtet ist, um den vorstehend genannten Abschirmeffekt zu erzielen.

Selbstverständlich ist es auch denkbar, dass die gesamte Montageeinheit 3 ein Isolationsmaterial aufweist.

Das Gehäuse 8 einer jeden Schalteinheit 2 ist im wesentlichen quaderförmig ausgebildet, wobei die Ecken und Kanten des Gehäuses 8 zudem abgerundet sind. Durch diese Massnahme können lokale Erhöhungen des elektrischen Feldes an der Oberfläche des Gehäuses 8 vermieden werden, so dass eine weitere Verbesserung der Vermeidung von Teilentladungen und Überschlägen erreicht werden kann. Die Schalteinheiten 2 können demzufolge näher aneinander angeordnet werden, wodurch ein kompakterer und platzsparenderer Aufbau des leistungselektronischen Schaltsystems 1 erzielt werden kann.

Wie in Fig. 5 beispielhaft gezeigt, ist das Gehäuse 8 einer jeden Schalteinheit 2 mehrteilig ausgebildet, so dass die Montage des mindestens einen Schaltmoduls 9 innerhalb des Gehäuses 8 sowie die Montage und Fixierung der jeweiligen Schalteinheit 2 an der Haltevorrichtung 4 sehr einfach durchgeführt werden kann. Wie in Fig. 5 beispielhaft gezeigt, umfasst das Gehäuse 8 drei Teile, nämlich einen Oberteil 8.1, einen Mittelteil 8.2 und einen Unterteil 8.3. Denkbar sind auch lediglich zwei Teile oder mehr als drei Teile. Desweiteren sind Haltemittel 10 innerhalb des Gehäuses 8 einer jeden Schalteinheit 2 zur Aufnahme des mindestens einen Schaltmoduls 9 vorgesehen, wobei die Haltemittel 10 zum einfachen Einschub des mindestens einen Schaltmoduls 9 in das Gehäuse 8 dienen. Die Haltemittel 10 sind vorzugsweise schienenartig ausgebildet. Die Haltemittel 10 können zusätzlich auch derart ausgebildet sein, dass Sie der Fixierung des mindestens einen Schaltmoduls 9 an der Innenseite des Gehäuses 8 dienen.

Vorzugsweise umfasst die Haltevorrichtung 4 zwei Schenkel 5, insbesondere mit jeweils einer Vielzahl an Vorsprüngen 6 zur Aufnahme der jeweiligen Schalteinheit 2. Wie bei der Ausführungsform nach Fig. 2 gezeigt, muss die jeweilige Schalteinheit 2 bei der Montage lediglich auf einen Vorsprung 6 des einen und des anderen Schenkels 5 aufgesteckt werden und danach an den zugehörigen Vorsprüngen 6 der Schenkel 5 fixiert werden. Die Fixierung erfolgt mit in Fig. 3 angedeuteten Plattenelementen. Wie in Fig. 1, Fig. 2 und Fig. 3 gezeigt, sind die Vorsprünge 6 des jeweiligen Schenkels 5 in Längsrichtung X des jeweiligen Schenkels 5 angeordnet. Bevorzugt sind die die Vorsprünge 6 eines Schenkels 5 dabei äquidistant beabstandet. Weiterhin entspricht die Anzahl der Vorsprünge 6 des einen Schenkels 5 der Anzahl Vorsprünge 6 des anderen Schenkels 5. Wie in Fig. 5, Fig. 6 und Fig. 7 gezeigt, ist es auch denkbar, dass die jeweilige Schalteinheit 2 bei der Montage zwischen zwei Vorsprüngen 6 fixiert wird, wobei das Unterteil 8.3 des Gehäuses 8 der Schalteinheit 2 dann die Schenkel 5 zumindest teilweise umschliesst. Wie in Fig. 7 beispielhaft gezeigt, erfolgt die Fixierung mit in Fig. 7 angedeuteten Plattenelementen. Desweiteren sind die Schenkel 5 vorteilhaft im wesentlichen parallel zueinander angeordnet.

Bevorzugt ist für jede Schalteinheit 2 ein elektrischer Energiespeicher 2 vorgesehen, wie in Fig. 5 und Fig. 6 beispielhaft gezeigt. Der elektrische Energiespeicher 2 ist mit dem mindestens einen Schaltmodul 9 der zugehörigen Schalteinheit 2 verbunden. Der elektrische Energiespeicher und das mindestens eine Schaltmodul sind in Fig. 1, Fig. 2, Fig. 3, Fig. 4 und Fig. 7 der Übersichtlichkeit halber nicht dargestellt. Zu Abschirmzwecken ist der jeweilige elektrische Energiespeicher 2 optional auch vom Gehäuse 8 der jeweiligen Schalteinheit 2 umschlossen und somit innerhalb des Gehäuses 8 angeordnet, wie in Fig. 5 und Fig. 6 beispielhaft dargestellt.

Gemäss Fig. 1 bis Fig. 6 sind die Schalteinheiten 2 entlang beider Schenkel 5 nebeneinander angeordnet, wobei jeweils benachbarte Schalteinheiten 2, insbesondere benachbarte Gehäuse 8 der Schalteinheiten 2, mittels mindestens eines Abstandselementes 7 zueinander beanstandet und miteinander verbunden sind. Vorzugsweise weist das Abstandselement 7 ein Isolationsmaterial zur elektrischen Isolation der mit dem Abstandselement 7 verbundenen Schalteinheiten 2 auf. Demzufolge dient das Abstandselement 7 einerseits der elektrischen Isolation benachbarter Schalteinheiten 2 gegeneinander und andererseits der Fixierung benachbarter Schaleinheiten 2 miteinander, so dass ein kompakter, gegen mechanische Schwingungen weitestgehend unempfindlicher und damit insgesamt robuster Verbund der Schalteinheiten 2 entsteht. Das erfindungsgemässe Schaltsystem 1 eignet sich somit für Anwendungen in einem rauen Umfeld und ist beispielsweise prädestiniert für Traktionsanwendungen.

Es ist denkbar, dass die Montageeinheit 3 einstückig ausgebildet ist. In diesem Fall ist die Montageeinheit 3 beispielsweise durch Giessen oder durch ein anderes Formgebungsverfahren eines Isolationsmaterials sehr einfach herstellbar.

Das Gehäuse 8 einer jeden Schalteinheit 2 nach den Ausführungsformen gemäss Fig. 1 bis Fig. 6 weist eine Vielzahl an Öffnungen auf. Diese Öffnungen dienen einerseits der Kühlung des innerhalb des jeweiligen Gehäuses 8 angeordneten mindestens einen Schaltmoduls 9 beispielsweise mit Luft. Andererseits können die Öffnungen auch zur Durchführung von Versorgungs-, Verbindungs- und/oder Steuerleitungen zum mindestens einen Schaltmodul 9 genutzt werden. Desweiteren erleichtern die Öffnungen den Zugang zum Inneren des Gehäuses 8 bei Wartungszwecken und/der bei der Montage des mindestens Schaltmoduls 9 innerhalb des Gehäuses 8.

### Bezugszeichenliste

- 1: leistungselektronisches Schaltsystem
- 2: Schalteinheit
- 3: Montageeinheit
- 4: Haltevorrichtung
- 5: Schenkel
- 6: Vorsprung
- 7: Abstandselement
- 8: Gehäuse der Schalteinheit
- 8.1: Oberteil des Gehäuses der Schalteinheit
- 8.2: Mittelteil des Gehäuses der Schalteinheit
- 8.3: Unterteil des Gehäuses der Schalteinheit
- 9: Schaltmodul
- 10: Haltemittel
- 11: elektrischer Energiespeicher

## Patentansprüche

1. Leistungselektronisches Schaltsystem (1) mit einer Vielzahl an Schalteinheiten (2), wobei jede Schalteinheit (2) ein Gehäuse (8) und mindestens ein innerhalb des Gehäuses (8) angeordnetes Schaltmodul (9) aufweist, und mit einer Montageeinheit (3), wobei die Montageeinheit (3) eine Haltevorrichtung (4) aufweist, an welcher Haltevorrichtung (4) die Gehäuse (8) der Schalteinheiten (2) angeordnet sind, wobei die Haltevorrichtung (4) ein Isolationsmaterial zur elektrischen Isolation der Haltevorrichtung (4) gegenüber den Gehäusen (8) der Schalteinheiten (2) und gegenüber den Gehäusen (8) der Schalteinheiten (2) untereinander aufweist, wobei das Gehäuse (8) einer jeden Schalteinheit (2) ein Material zur zumindest teilweisen Abschirmung eines elektrischen und magnetischen Feldes aufweist, **dadurch gekennzeichnet, dass** die Haltevorrichtung (4) zwei Schenkel (5) zur Fixierung des jeweiligen Gehäuses (8) der Schalteinheit (2) an der Haltevorrichtung (4) umfasst, und dass die Schalteinheiten (2) entlang beider Schenkel (5) nebeneinander angeordnet sind, wobei jeweils benachbarte Schalteinheiten (2) mittels mindestens eines Abstandselementes (7) zueinander beanstandet und miteinander verbunden sind, wobei das Abstandselement (7) ein Isolationsmaterial zur elektrischen Isolation der mit dem Abstandselement (7) verbundenen Schalteinheiten (2) aufweist.

2. Leistungselektronisches Schaltsystem (1) nach Anspruch 1, **dadurch gekennzeichnet, dass** das Gehäuse (8) einer jeden Schalteinheit (2) im wesentlichen quaderförmig ausgebildet ist, wobei die Ecken und Kanten des Gehäuses (8) abgerundet sind.

3. Leistungselektronisches Schaltsystem (1) nach Anspruch 1 oder 2, **dadurch gekennzeichnet, dass** das Gehäuse (8) einer jeden Schalteinheit (2) mehrteilig ausgebildet ist.

4. Leistungselektronisches Schaltsystem (1) nach einem der Ansprüche 1 bis 3, **dadurch gekennzeichnet, dass** Haltemittel (10) innerhalb des Gehäuses (8) einer jeden Schalteinheit (2) zur Aufnahme des mindestens einen Schaltmoduls (9) vorgesehen sind.

5. Leistungselektronisches Schaltsystem (1) nach Anspruch 4, **dadurch gekennzeichnet, dass** die Haltemittel (10) schienenartig ausgebildet sind.

6. Leistungselektronisches Schaltsystem (1) nach Anspruch 1, **dadurch gekennzeichnet, dass** die Schenkel (5) im wesentlichen parallel zueinander angeordnet sind.

7. Leistungselektronisches Schaltsystem (1) nach einem der Ansprüche 1 bis 6, **dadurch gekennzeichnet, dass** die Montageeinheit (3) einstückig ausgebildet ist.

8. Leistungselektronisches Schaltsystem (1) nach einem der Ansprüche 1 bis 7, **dadurch gekennzeichnet, dass** für jede Schalteinheit (2) ein elektrischer Energiespeicher (11) vorgesehen ist, welcher elektrische Energiespeicher (11) mit dem mindestens einen Schaltmodul (9) der zugehörigen Schalteinheit (2) verbunden ist.

9. Leistungselektronisches Schaltsystem (1) nach Anspruch 8, **dadurch gekennzeichnet, dass** der elektrische Energiespeicher (11) innerhalb des Gehäuses (8) der zugehörigen Schalteinheit (2) angeordnet ist.

10. Leistungselektronisches Schaltsystem (1) nach einem der Ansprüche 1 bis 9, **dadurch gekennzeichnet, dass** das Gehäuse (8) einer jeden Schalteinheit (2) eine Vielzahl an Öffnungen aufweist.

## Claims

1. Power-electronic switching system (1) having a large number of switching units (2), wherein each switching unit (2) has a housing (8) and at least one switching module (9) which is arranged within the housing (8), and
having a mounting unit (3), wherein the mounting unit (3) has a holding apparatus (4), on which holding apparatus (4) the housings (8) of the switching units (2) are arranged,
wherein the holding apparatus (4) comprises an insulation material for electrically insulating the holding apparatus (4) from the housings (8) of the switching units (2) and from the housings (8) of the switching units (2) from one another, wherein the housing (8) of each switching unit (2) comprises a material for at least partially shielding an electric and magnetic field,
**characterized in that** the holding apparatus (4) comprises two limbs (5) for fixing the respective housing (8) of the switching unit (2) to the holding apparatus (4), and
**in that** the switching units (2) are arranged next to one another along the two limbs (5), wherein respectively adjacent switching units (2) are separated from one another and connected to one another by means of at least one spacer element (7), wherein the spacer element (7) comprises an insulation material for electrically insulating the switching units (2) which are connected to the spacer element (7).

2. Power-electronic switching system (1) according to Claim 1, **characterized in that** the housing (8) of each switching unit (2) is of substantially cuboidal design, wherein the corners and edges of the housing (8) are rounded.

3. Power-electronic switching system (1) according to Claim 1 or 2, **characterized in that** the housing (8) of each switching unit (2) is of multipartite design.

4. Power-electronic switching system (1) according to one of Claims 1 to 3, **characterized in that** holding means (10) are provided within the housing (8) of each switching unit (2) for the purpose of holding the at least one switching module (9).

5. Power-electronic switching system (1) according to Claim 4, **characterized in that** the holding means (10) are of rail-like design.

6. Power-electronic switching system (1) according to Claim 1, **characterized in that** the limbs (5) are arranged substantially parallel to one another.

7. Power-electronic switching system (1) according to one of Claims 1 to 6, **characterized in that** the mounting unit (3) is of integral design.

8. The power-electronic switching system (1) according to one of Claims 1 to 7 **characterized in that** an electrical energy store (11) is provided for each switching unit (2), said electrical energy store (11) being connected to the at least one switching module (9) of the associated switching unit (2).

9. Power-electronic switching system (1) according to Claim 8, **characterized in that** the electrical energy store (11) is arranged within the housing (8) of the associated switching unit (2).

10. Power-electronic switching system (1) according to one of Claims 1 to 9, **characterized in that** the housing (8) of each switching unit (2) has a large number of openings.

## Revendications

1. Système de commutation électronique de puissance (1) présentant une pluralité d'unités de commutation (2), chaque unité de commutation (2) présentant un boîtier (8) et au moins un module de commutation (9) disposé à l'intérieur du boîtier (8), et
comprenant une unité de montage (3), l'unité de montage (3) présentant un dispositif de retenue (4), dispositif de retenue (4) sur lequel sont disposés les boîtiers (8) des unités de commutation (2),
dans lequel le dispositif de retenue (4) présente un matériau d'isolation pour l'isolation électrique du dispositif de retenue (4) par rapport aux boîtiers (8) des unités de commutation (2) et par rapport aux boîtiers (8) des unités de commutation (2) entre eux,
dans lequel le boîtier (8) de chacune des unités de commutation (2) présente un matériau assurant une protection, au moins partielle, contre un champ électrique et magnétique,
**caractérisé en ce que** le dispositif de retenue (4) comprend deux pattes (5) permettant de fixer le boîtier respectif (8) de l'unité de commutation (2) au dispositif de retenue (4), et
**en ce que** les unités de commutation (2) sont disposées côte à côte le long des deux pattes (5), les unités de commutation adjacentes (2) étant espacées l'une de l'autre au moyen d'au moins un élément d'espacement (7) et étant reliées l'une à l'autre, l'élément d'espacement (7) présentant un matériau isolant pour l'isolation électrique des unités de commutation (2) reliées à l'élément d'espacement (7).

2. Système de commutation électronique de puissance (1) selon la revendication 1, **caractérisé en ce que** le boîtier (8) de chacune des unités de commutation (2) est réalisé de manière à présenter une forme sensiblement rectangulaire, les angles et les arêtes du boîtier (8) étant arrondis.

3. Système de commutation électronique de puissance (1) selon la revendication 1 ou 2, **caractérisé en ce que** le boîtier (8) de chacune des unités de commutation (2) est réalisé en plusieurs parties.

4. Système de commutation électronique de puissance (1) selon l'une quelconque des revendications 1 à 3, **caractérisé en ce qu'**il est prévu des moyens de retenue (10) à l'intérieur du boîtier (8) de chacune des unités de commutation (2) pour recevoir l'au moins un module de commutation (9).

5. Système de commutation électronique de puissance (1) selon la revendication 4, **caractérisé en ce que** les moyens de retenue (10) sont réalisés sous la forme de rails.

6. Système de commutation électronique de puissance (1) selon la revendication 1, **caractérisé en ce que** les pattes (5) sont disposées sensiblement parallèlement l'une à l'autre.

7. Système de commutation électronique de puissance (1) selon l'une quelconque des revendications 1 à 6, **caractérisé en ce que** l'unité de montage (3) est réalisée d'un seul tenant.

8. Système de commutation électronique de puissance (1) selon l'une quelconque des revendications 1 à 7, **caractérisé en ce que**, pour chaque unité de commutation (2), il est prévu un accumulateur d'énergie électrique (11), lequel accumulateur d'énergie électrique (11) est relié à l'au moins un module de commutation (9) de l'unité de commutation (2) correspondante.

9. Système de commutation électronique de puissance (1) selon la revendication 8, **caractérisé en ce que** l'accumulateur d'énergie électrique (11) est disposé à l'intérieur du boîtier (8) de l'unité de commutation (2) correspondante.

10. Système de commutation électronique de puissance (1) selon l'une quelconque des revendications 1 à 9, **caractérisé en ce que** le boîtier (8) de chacune des unités de commutation (2) présente une pluralité d'ouvertures.
